# EUROPEAN PATENT SPECIFICATION

(11) **EP 1 016 942 B1**
(45) Date of publication and mention of the grant of the patent: **25.05.2005**
(21) Application number: 99126011.8
(22) Date of filing: 27.12.1999
(51) Int. Cl.: G03G 15/20

(54) **Fixing device comprising two rotary members**
Fixiervorrichtung mit zwei rotierenden Elementen
Dispositif de fixage à deux éléments rotatifs

(30) Priority: 28.12.1998 JP 37314498
(43) Date of publication of application: 05.07.2000
(73) Proprietor: CANON KABUSHIKI KAISHA, Tokyo (JP)
(72) Inventor: Watanabe, Osamu, Ohta-ku, Tokyo (JP); Takeuchi, Yasushi, Ohta-ku, Tokyo (JP)
(74) Representative: Pellmann, Hans-Bernd, Dipl.-Ing.

(56) References cited:
- US-A- 4 596 920
- US-A- 4 935 785
- PATENT ABSTRACTS OF JAPAN vol. 1996, no. 09, 30 September 1996 (1996-09-30) & JP 08 137307 A (CANON INC), 31 May 1996 (1996-05-31)
- PATENT ABSTRACTS OF JAPAN vol. 014, no. 409 (P-1101), 5 September 1990 (1990-09-05) & JP 02 158783 A (CANON INC), 19 June 1990 (1990-06-19)

## Description

### BACKGROUND OF THE INVENTION

### Field of the Invention

The present invention relates to a fixing device provided in an image forming apparatus using the electrophotography system, such as a printer, a copying machine or a facsimile machine, and to a rotary member for fixing adapted for the fixing device.

### Description of Related Art

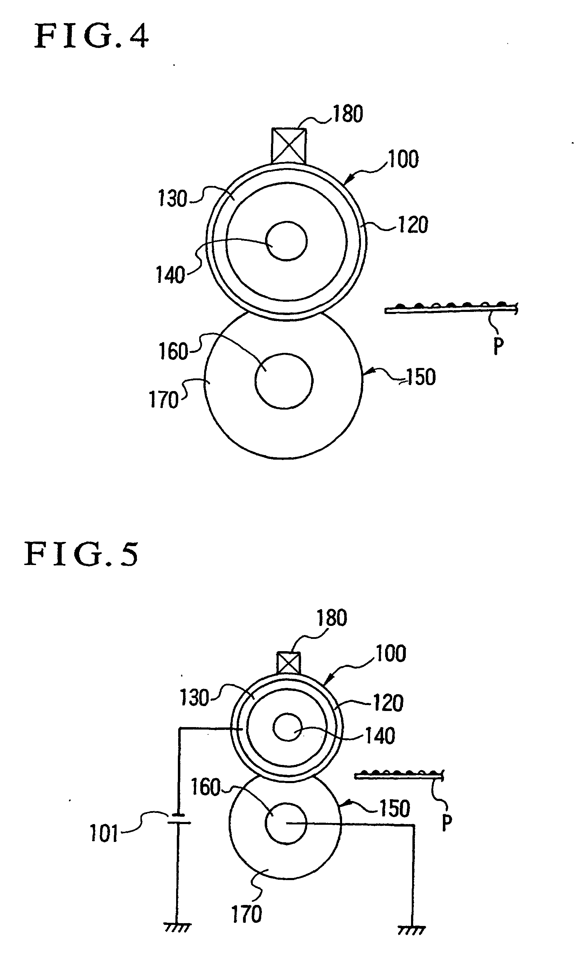

A fixing device provided in an image forming apparatus, such as an electrophotographic copying machine, is conventionally provided with a fixing roller 100 and a pressing roller 150 rotating in contact therewith, as shown in Fig. 4. The fixing roller 100 is composed of a hollow core metal 130 of which the outer peripheral surface is covered with a releasing layer 120 or the like, and a heater 140 is disposed inside the core metal 130.

The aforementioned pressing roller 150 is formed by covering the outer peripheral surface of the core metal 160 with an elastic layer 170, and the pressing roller 150 forms a nip part for nipping and conveying a transfer member P in cooperation with the fixing roller 100.

A separating claw (not shown) for preventing entanglement of the transfer member P on the fixing roller 100 and a temperature detecting element 180 for detecting the surface temperature of the fixing roller 100 are disposed around the fixing roller 100. The temperature detecting element 180 outputs a temperature detection signal indicative of the surface temperature of the fixing roller 100, and the temperature detection signal is supplied to a temperature control circuit (not shown). Then, the temperature control circuit ON/OFF-controls the operation of the heater 140 on the basis of the temperature detection signal, and the surface temperature of the fixing roller 100 is maintained at a predetermined temperature through the ON-OFF operations of the heater 140.

Then, in the process of fixing, the transfer member P having an unfixed toner image born thereon is inserted into the nip part between the fixing roller 100 and the pressing roller 150. While the transfer member P passes through the nip part, the unfixed toner image on the transfer member P is made to fuse and adhere to the transfer member P under the effect of heat and pressure, so that a permanent image is formed on the transfer member P.

However, on some occasions, a part of the toner forming the unfixed toner image on the transfer member P may transfer onto the surface of the fixing roller 100, so that the toner may adhere to the surface of the fixing roller 100 (known as the offsetting phenomenon). The toner adhering to the surface of the fixing roller 100 adheres again to the next transfer member P, which has been conveyed subsequently, so that the transfer member P may be contaminated by the toner.

Conceivable causes of the above-mentioned offsetting phenomenon include physical coherence and electrostatic force between the toner and the fixing roller 100. Occurrence of the offsetting phenomenon caused by the physical coherence between the toner and the fixing roller 100 can be inhibited by increasing smoothness of the surface of the fixing roller 100, and also by reducing the surface energy of the fixing roller 100. It is, therefore, possible to inhibit occurrence of the offsetting phenomenon caused by the physical coherence between the toner and the fixing roller 100, by the presence of the releasing layer 120 formed on the surface of the fixing roller 100.

The electrostatic force causing occurrence of the offsetting phenomenon is, in contrast, an electrostatic force acting on the toner which is a charged powder in an electric field formed by the fixing roller 100, the pressing roller 150 and the transfer member P charged by frictions, peeling, etc. Thus, the toner transfers to the surface of the fixing roller 100 under the effect of the attraction acting between the toner and the fixing roller 100 and the repulsive force acting between the toner and the pressing roller 150 or the repulsive force acting between the toner and the transfer member P.

With a view to inhibiting occurrence of the offsetting phenomenon under the above-mentioned electric effect, there has been proposed a method of preventing the transfer of the toner by an electric field formed between the fixing roller 100 and the pressing roller 150 by applying to the fixing roller 100 a voltage of the same polarity as that of the charge of the toner forming a toner image (as disclosed in Japanese Laid-Open Patent Application No. Hei 3-217885).

An example of the fixing device adopting the aforementioned method proposed as above is illustrated in Fig. 5. Fig. 5 is a partial configuration diagram of the fixing device. The same reference numerals are assigned in Fig. 5 to the same elements as in Fig. 4.

In the fixing device shown in Fig. 5, there is provided a power source 101 for applying to the core metal 130 of the fixing roller 100 a bias voltage of the same polarity as that of the charge of the toner forming a toner image. In this fixing device, an electric field is formed at the nip part between the fixing roller 100 and the pressing roller 150 by the bias voltage applied to the core metal 130 of the fixing roller 100, so that the transfer of the toner having the same polarity as the bias voltage to the releasing layer 120 of the fixing roller 100 can be prevented

Further, the bias voltage being applied causes stabilization of the potential of the surface of the fixing roller 100, and stabilization of the electric field acting between the fixing roller 100 and the pressing roller 150. Therefore, if no bias voltage is applied, sliding friction with the pressing roller 150 or charging from the transfer member P causes charge-up of the releasing layer 120. In this instance, the offsetting phenomenon is caused by components having an inverted charge contained in the developing agent (known as the inverted toner) or a filler of the polarity opposite to that of the developing agent contained in the transfer member P, adhering to the fixing roller 100, thus posing problems such as occurrence of electrostatic noise cause by charge leakage. It is, therefore, desirable to stabilize the surface potential of the fixing roller 100 by applying a bias voltage.

However, when applying a bias voltage onto the fixing roller as described above, the following problems are encountered.
1) In order to prevent leakage of a bias voltage, it is necessary to ensure a sufficient distance of the fixing roller from the surrounding metal members, thus making it difficult to downsize the apparatus as a whole.
2) The necessity to provide electrodes and a high-voltage power source for applying a bias voltage leads to an increase of cost.
3) Because the contact between the electrodes for applying a bias voltage and the roller is formed by a brush or the like, there may occur a defective contact, thus causing unavailability of an expected effect of application of the bias voltage or occurrence of noise.

US-A-4 935 785 describes a cylindrical fuser roll suitable for fusing electrophotographic images to a substrate, wherein the fuser roll comprises a polymeric electret material having embedded therein stable electrical charges of the same polarity as that of the toner. Furthermore, the fusing apparatus disclosed in this patent comprises a pressing roller abutting on the fixing roller having a surface layer made of Teflon or polytetrafluoroethylene.

JP-A-08-137 307 describes a fixing device using a fixing film an a pressing roller for fixing xerographic toner images.

### BRIEF SUMMARY OF THE INVENTION

An object of the present invention is, therefore, to provide a fixing device having a rotary member for fixing capable of preventing occurrence of the offsetting phenomenon of toner onto the rotary member.

An aspect of the present invention is to provide a first and a second rotary member for fixing an unfixed toner image at a nip portion for nipping and conveying a recording member, both rotary member have an electret-treated releasing layer provided on the surface of the rotary member, and a fixing device having the two rotary members for fixing according to claim 1.

The above and further objects and features of the present invention will become apparent from the following detailed description of preferred embodiments thereof taken in conjunction with the accompanying drawings.

### BRIEF DESCRIPTION OF THE SEVERAL VIEWS OF THE DRAWING

Fig. 1 is a partial configuration diagram showing a fixing device according to a first embodiment
Fig. 2 is an enlarged sectional view of a pressing roller having an electret-treated releasing layer.
Fig. 3 is a schematic sectional view of a fixing device according to a second embodiment.
Fig. 4 is a partial configuration diagram of a conventional fixing device.
Fig. 5 is a partial configuration diagram of another conventional fixing device.

### DETAILED DESCRIPTION OF THE INVENTION

Hereinafter, the present invention will be described in detail with reference to the drawings.

### <First Embodiment>

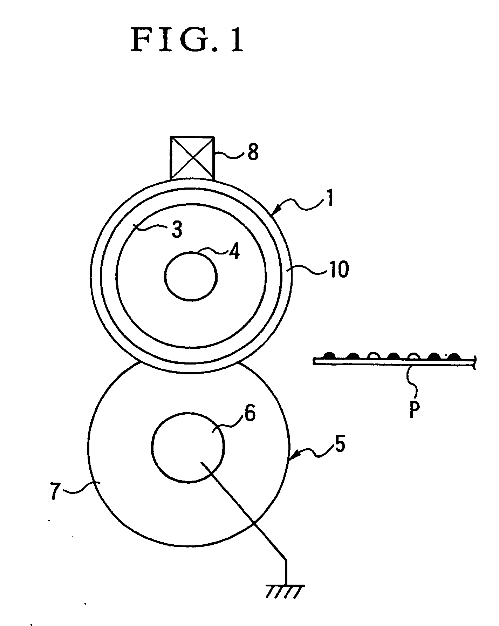

Fig. 1 is a partial configuration diagram showing a fixing device according to a first embodiment.

The fixing device according to the first embodiment has a fixing roller 1 and a pressing roller 5 which rotates in contact with the fixing roller 1. The fixing roller 1 is composed of a core metal 3 which is a hollow substrate of which the outer peripheral surface is covered with a releasing layer 10. The outside diameter of the fixing roller 1 is set to 20 mm, and a heater 4 is disposed inside the core metal 3 of the fixing roller 1. In the case of the first embodiment, the thickness of the releasing layer 10 is set to 30 µm, and the core metal 3 is composed of a hollow cylindrical member made of an aluminum material and has a thickness set to 3 mm.

Further, the pressing roller 5 has a core metal 6 serving as the substrate thereof, and the outer peripheral surface of the core metal 6 is covered with an elastic layer 7. In the first embodiment, the elastic layer 7 is composed of a silicone rubber material in which a surfactant is dispersed. The elastic layer 7 is made conductive by the addition of a conductive filler, and the surface of the pressing roller 5 is grounded via the core metal 6. The thickness of the elastic layer 7 is set to 4 mm, and the volume resistance of the elastic layer 7 is a value ranging from 10¹⁰ to 10¹² Ωcm. The pressing roller 5 has an outside diameter of 16 mm and forms, in cooperation with the fixing roller 1, a nip part for nipping and conveying a transfer member P, which is a recording member.

Further, a temperature detecting element 8 for detecting the surface temperature of the fixing roller 1 is disposed around the fixing roller 1. The temperature detecting element 8 outputs a temperature detection signal indicative of the surface temperature of the fixing roller 1. The temperature detection signal is supplied to a temperature control circuit (not shown). Then, the temperature control circuit ON/OFF-controls operations of the heater 4 on the basis of the temperature detection signal, so that the surface temperature of the fixing roller 1 is kept at a predetermined level through ON/OFF operations of the heater 4.

Further, the releasing layer 2 of the fixing roller 1 is electret-treated. The electret treatment will now be described.

Materials to which the electret treatment is applicable include resins such as PFA (tetrafluoroethylene-perfluoroalkyl vinyl ether copolymer), PTFE (polytetra-fluoroethylene), FEP (tetrafluoroethylene-hexafluoropropylene copolymer), polypropylene, myra, silicone, epoxy resin, poly-1-olefins, polystyrene, polyamide, polyfluorovinylidene, polyvinyl halide, and polyalkyl methacrylate. Among others, fluorine resins, such as PTFE, FEP and PFA, usually used as a releasing layer for the fixing roller or the pressing roller should preferably be used.

These materials are converted into polymer electret by any of the following methods:
(1) Heating the polymer at the softening point or the glass transition temperature, and cooling it while applying a high DC voltage.
(2) Heating the polymer to a temperature over the glass transition temperature, and cooling it while conducting corona-charging.
(3) Irradiating a low-energy electron beam of 10 to 40 kV onto the polymer surface in vacuum.
(4) Cooling the polymer while applying a strong static magnetic field at a high temperature.

The roller having an electret-treated releasing layer may be formed, for example, by forming a resin film by applying the aforementioned manufacturing process in the middle of extrusion molding or injection molding, and then bonding the resin film to the core metal, or applying the treatment of the aforementioned manufacturing process to a resin coating beforehand formed on the core metal. In this process, the releasing layer on the core metal should have a thickness ranging from 10 to 300 µm, or preferably, from 30 to 200 µm.

In the first embodiment, PFA is used as the releasing layer 10 of the fixing roller 1. More specifically, an electret-treated PFA releasing layer 10 having a thickness of 30 µm is obtained by repeating five times steps of coating PFA by a usual method such as dispersion coating or powder coating onto the surface of the core metal 3, then conducting negative corona charging (-5 µA/cm²) for 20 minutes while heating the fixing roller 1 at 250°C, and then applying a treatment of rapid cooling. While the fixing roller 1 in the first embodiment has no elastic layer, the fixing roller may have an elastic layer and a releasing layer formed thereon.

To a fixing device using the aforementioned fixing roller 1 (hereinafter referred to as the "fixing device (b)"), 1,000 sheets of transfer member P bearing a toner image having a negative polarity were fed, and the amount of offsetting of the toner adhering to the fixing roller 1 and the pressing roller 5 was measured. As shown in Table 1, the electret-treated one showed a remarkably reduced amount of offsetting as compared with non-electret-treated one (hereinafter referred to as the "fixing device (a)"). This is attributable to the fact that the electret treatment caused the PFA releasing layer 10 to be constantly and stably negatively charged to have a negative potential, and there occurred an electric field in a direction from the pressing roller 5 toward the fixing roller 1, thus preventing the negatively charged toner from adhering.

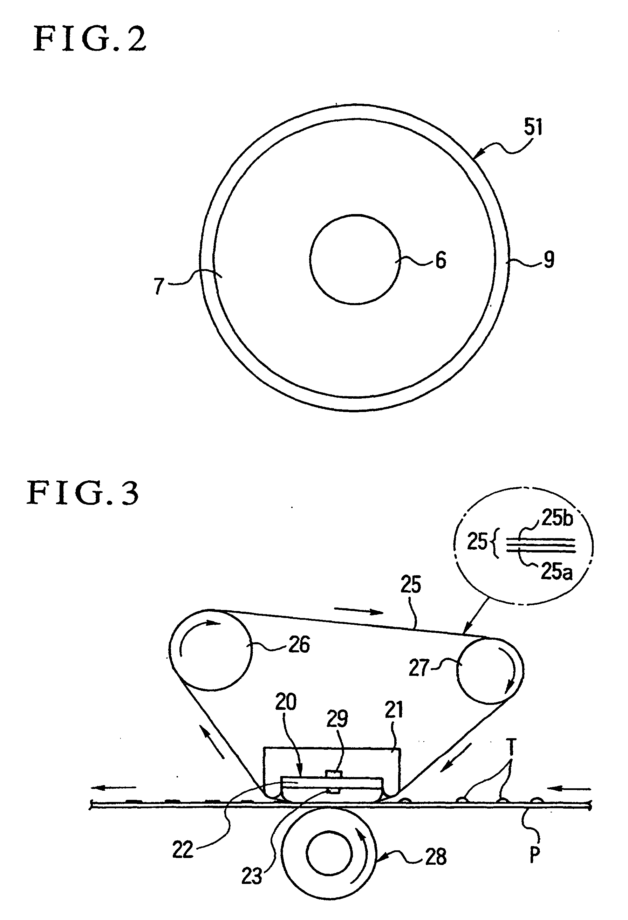

An electret treatment was applied by repeating a process comprising the steps of heating a PFA tube of thickness of 50 µm to 250°C, and then, cooling the PFA tube while applying a DC voltage of 300 V. A pressing roller 51 having a releasing layer 9 as shown in Fig. 2 formed thereon and made of this tube was manufactured. This pressing roller 51 was incorporated into the fixing device having an electret-treated fixing roller (hereinafter referred to as the "fixing device (c)"), and the amount of offsetting was measured under the same conditions. In this case, the amount of offsetting was further reduced as shown in Table 1. This is attributed to the fact that, because the surface of the pressing roller 51 was stably charged positively, the magnitude of charge in a direction from the pressing roller 51 toward the fixing roller 1 increased.

**Table 1**

| Fixing device | Fixing roller Electret treatment | Pressing roller Electret treatment | Pressing roller → Fixing roller Size of electric field | Amount of offsetting (mg/cm²) |
|---|---|---|---|---|
| (a) | None | None | -100 V | 10 |
| (b) | Treated | None | +200 V | 2 |
| (c) | Treated | Treated | +600 V | 0.4 |
| * Counter electric field when it is negative | | | | |

### <Second Embodiment>

A second embodiment will now be described with reference to Fig. 3.

Fig. 3 is a schematic sectional view of a fixing device according to the second embodiment. In Fig. 3, reference numeral 25 denotes a heat-resistant film composed of an endless-belt-shaped film, which is wound and stretched among a driving roller 26, a follower roller 27 and a heater 20 held by a heater support 21 below the space between the both rollers 26 and 27.

The follower roller 27 serves also as a tension roller for the heat-resistant film 25. The heat-resistant film 25 is driven to rotate clockwise at a predetermined speed along with the clockwise driving rotation of the driving roller 26 (i.e., at a circumferential speed equal to the conveying speed of the transfer member P as a heated member bearing, on the upper surface thereof, an unfixed toner image T sent form the side of an image forming part (not shown)) without wrinkles, zigzag or a delay in speed.

A pressing roller 28 has an elastic layer made of rubber excellent in releasability, such as silicone rubber. The pressing roller 28 is brought into pressure-contact with the lower surface of the heater 20 by an urging means under a total contact pressure of 4 to 10 kg while nipping a lower portion of the heat-resistant film 25 between the pressing roller 28 and the heater 20, and is caused to rotate counterclockwise in the forward direction which is the same as the conveying direction of the transfer member P.

The heater 20 is composed of an electric-resistant material 23 having a width of 2.5 mm and a length of 300 mm coated onto a substrate 22 made of a high-heat-conductivity material (for example, alumina, or aluminum nitride) having a thickness of 1.0 mm, a width of 10 mm and a length of 350 mm, and thermal energy is generated by supplying electric power to the electric-resistant material 23.

Further, a temperature sensor 29 serving as temperature detecting means is attached to the back surface of the substrate of the heater 20. An energizing control part (not shown) serving as energizing control means is connected to the temperature sensor 29. The energizing control part controls electric power to be supplied to the heater 20 in accordance with the temperature detected by the temperature sensor 29 so that the substrate of the heater 20 has a prescribed set temperature (conditioning temperature) during execution of the image forming operation.

The heater support 21 is made of a highly-heat-resistant resin, such as PPS (polophenylene sulfide), PAI (polyamideimide), PI (polyimide), PEEK (polyether-etherketone) or a liquid crystal polymer, or a composite material thereof with a ceramics, a metal or glass.

The heat-resistant film 25 to be driven to rotate, because of being subjected to heating and fixing of the toner image repeatedly, has, in general, a small total thickness of not greater than 100 µm (preferably, not greater than 40 µm) and is excellent in heat resistance, releasability and durability. A single-layer film or a composite-layer film of heat-resistant resins, such as polyimide, polyetherimide, PES and PFA, (for example, a film having a thickness of 20 µm), is used as a base layer 25a which serves as the substrate of the heat-resistant film 25, and a releasing coat layer 25b is formed into a thickness of 10 µm by applying an electret treatment by the aforementioned method to a fluororesin, such as PFA, at least on the image contact side of the base layer 25a.

Then, the amount of offsetting was largely reduced by using the heat-resistant film 25 having the releasing coat layer electret-treated as in the second embodiment. The present invention is thus applicable also to a fixing device using a film.

In the present invention, as described above, the electret treatment is applied to the releasing layers, so that permanent polarization therefor occurs in the releasing layer, generating an external electric field. Then, the releasing layer is controlled to a potential of the same polarity as that of the developing agent. As a result, occurrence of the offsetting phenomenon is inhibited without the need of applying a bias voltage.

Although the present invention has been described with regard to the preferred embodiments thereof, the present invention is not limited to the above-described embodiments, but all variations are possible within the scope of the present invention as claimed.

## Claims

1. A fixing device adapted for an electrophotographic image forming apparatus comprising:
a first rotary member and a second rotary member for fixing an unfixed image onto a recording member at a nip portion for nipping and conveying said recording member, said first rotary member being provided at a side in contact with the unfixed toner image on the recording member and said second rotary member being provided at an opposite side of the side of the recording member on which the unfixed toner image is formed,
**characterized in that**
said first rotary member and said second rotary member have a releasing layer on a surface thereof, and said releasing layer being electret-treated.

2. A fixing device according to claim 1, wherein each of the releasing layers of said first rotary member and said second rotary member is a fluororesin layer.

3. A fixing device according to claim 2, wherein the fluororesin layer includes a tetrafluoroethyleneperfluoralkyl vinyl ether copolymer.

## Patentansprüche

1. Fixiervorrichtung, die für ein elektrophotographisches Bildbildungsgerät angepasst ist, die umfasst:
ein erstes rotierendes Element und ein zweites rotierendes Element zum Fixieren eines nicht-fixierten Bildes auf ein Aufzeichnungselement an einem Walzenspaltteil zum Einklemmen und Befördern des Aufzeichnungselementes, wobei das erste rotierende Element an einer Seite in Kontakt mit dem unfixierten Tonerbild auf dem Aufzeichnungselement bereitgestellt ist und das zweite rotierende Element an einer entgegen gesetzten Seite des Aufzeichnungselementes bereitgestellt ist, auf welchem das unfixierte Tonerbild ausgebildet ist,
**dadurch gekennzeichnet, dass**
das erste rotierende Element und das zweite rotierende Element auf deren Oberfläche eine Freisetzungsschicht besitzen, und die Freisetzungsschicht Elektret behandelt ist.

2. Fixiervorrichtung gemäß Anspruch 1, wobei jede der Freisetzungsschichten des ersten rotierenden Elementes und des zweiten rotierenden Elementes eine Fluorharzschicht ist.

3. Fixiervorrichtung gemäß Anspruch 2, wobei die Fluorharzschicht ein Tetrafluorethylenperfluoralkylvinylether-Copolymer beinhaltet.

## Revendications

1. Dispositif de fixage adapté à un appareil électrophotographique de formation d'images comportant :
un premier élément rotatif et un second élément rotatif destinés à fixer une image non fixée sur un support d'enregistrement dans une partie de pincement destinée à pincer et à transporter ledit support d'enregistrement, ledit premier élément rotatif étant situé sur un côté en contact avec l'image en toner non fixée sur le support d'enregistrement, et ledit second élément rotatif étant situé sur un côté opposé au côté de l'élément d'enregistrement sur lequel l'image en toner non fixée est formée,
**caractérisé en ce que**
ledit premier élément rotatif et ledit second élément rotatif ont une couche antiadhérente sur une surface de ces éléments, et ladite couche antiadhérente est traitée par électret.

2. Dispositif de fixage selon la revendication 1, dans lequel chacune des couches antiadhérentes dudit premier élément rotatif et dudit second élément rotatif est une couche de résine fluorée.

3. Dispositif de fixage selon la revendication 2, dans lequel la couche de résine fluorée comprend un copolymère tétrafluoréthylène-éther de perfluoralkylvinyle.
